# EUROPEAN PATENT APPLICATION

(11) **EP 4 525 224 A1**
(43) Date of publication of application: **19.03.2025**
(21) Application number: 23912968.7
(22) Date of filing: 28.12.2023
(51) Int. Cl.: H01S 5/024, H10N 10/80, H01S 5/40, H01S 5/02251, H01S 5/125, G02B 6/293, G02B 6/12, G02B 6/42

(54) **DWDM OPTICAL ELEMENT HAVING TWO LIGHT SOURCE CHIPS**

(30) Priority: 28.12.2022 KR 20220187072
(71) Applicant: Phovel Co. Ltd., Daejeon 34302 (KR)
(72) Inventor: KIM, Jeong Soo, Janggun-myeon, Sejong 30056 (KR)
(74) Representative: von Bülow & Tamada
(86) International application number: PCT/KR2023/021815
(87) International publication number: WO 2024/144294

(57) **Abstract**

Provided is a dense wavelength division multiplexing (DWDM) optical device having two light source chips, in which two or more semiconductor laser diode chips, respectively corresponding to a plurality of wavelength channels, are combined into one optical device package, and the respective semiconductor lasers are simultaneously driven to have a transmission speed twice faster than a case of driving one semiconductor laser.

## Description

### [Technical Field]

The present invention relates to a dense wavelength division multiplexing (DWDM) optical device, and more particularly, to a DWDM optical device having two light source chips, in which two or more semiconductor laser diode chips, respectively corresponding to a plurality of wavelength channels, are combined into one optical device package, and the respective semiconductor lasers are simultaneously driven to have a transmission speed twice faster than a case of driving one semiconductor laser.

### [Background Art]

Previously, several methods have been proposed to bundle laser diode (LD) chips into one package.

As shown in FIG. 1, US Patent No. US 7,184,621 proposes a method of manufacturing, in one package, four laser diode chips having wavelength intervals of about 20 nm or more, such as 12757 nm, 13002 nm, 13247 nm, and 13492 nm. A beam splitting (or beam combining) filter may be used to combine two different wavelengths into one optical path. The beam splitting filter is a filter transmitting a specific wavelength and reflecting another specific wavelength. This beam splitting filter may function to bundle light having different wavelengths into one optical path based on a path of incident light, and simultaneously separate different wavelengths having the same optical path into different optical paths. Therefore, the beam splitting filter may simultaneously function as the beam combining filter. In US Patent No. US 7,184,621, the optical path of each laser light is adjusted using a filter having an incident angle of 45 degrees for each laser light in order to collect laser lights having wavelength intervals of about 20 nm or more into one optical path. However, in the case of the filter disposed at 45 degrees, a transmission/reflection wavelength may be shifted based on an incident angle of laser light incident on each filter.

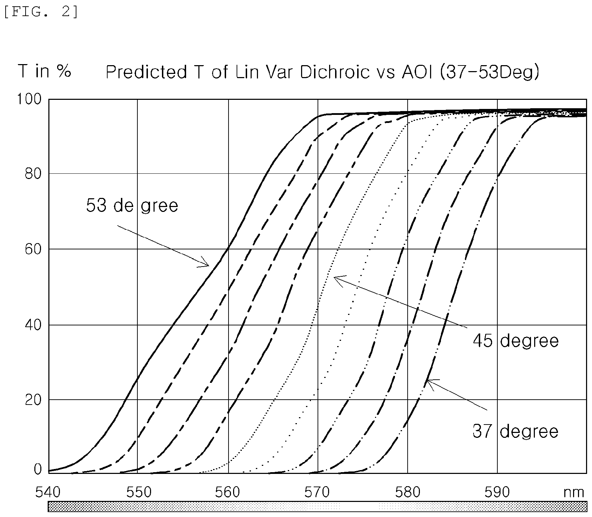

FIG. 2 shows that in a case of a dichroic filter whose transmission/reflection varies based on the wavelength, a transmission/reflection wavelength band varies based on the incident angle of light. In a wavelength band of 1300 to 1600 nm, the dichroic filter shows a transmission/reflection wavelength shift of about 6 nm when the incident angle of light is changed by about 1 degree based on 45 degrees. Therefore, when using the 45-degree filter, a wavelength band in which a transmission/reflection feature is unable to be controlled based on an adjustment degree of the incident angle of light may exist.

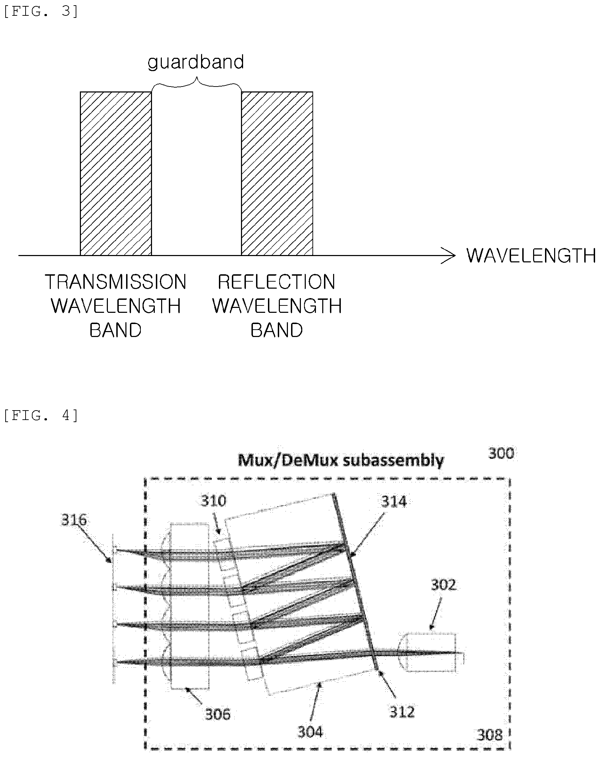

FIG.3 shows a transmission/reflection/guardband of a wavelength filter. As shown in FIG. 3, it is necessary to adjust accuracy of the incident angle of light incident on the dichroic filter based on a wavelength width of a guardband between a transmission wavelength band and a reflection wavelength band.

That is, as disclosed above in US Patent No. US 7,184,621, when the guardband between the wavelength bands to be combined to each other has a width of 6 nm or more, it is possible to adjust the incident angle of light incident on the 45-degree dichroic filter to be within +/-1 degree. However, when using the 45-degree dichroic filter, if the guardband has a width within 0.6 nm, it may be inconvenient to very precisely adjust the incident angle of light incident on the dichroic filter to be within 0.1 degree.

That is, in order to combine two or more wavelengths into one optical path by using a conventional 45-degree dichroic filter, an appropriate guardband may be required to exist between each wavelength band.

Optical communications may increase effectiveness of an optical fiber by using a wavelength division multiplexing (WDM) technology for simultaneously using a plurality of wavelengths in one optical fiber. In this method, the WDM having a narrow wavelength interval in which each optical communication channel has a wavelength interval of 100 GHz (about 0.6 nm to 0.8 nm) may be referred to as dense WDM (DWDM). The DWDM has a narrow wavelength interval of 100 GHz. When the guardband, which is the minimum wavelength interval between the channels, is 0.6 nm to 0.8 nm or less, the incident angle of light incident on the filter is required to be adjusted very precisely to be within 0.1 degree. This method is practically impossible, and it is thus difficult to apply the method of US Patent No. US 7,184,621 to combine DWDM-class lasers having the guardband within 0.8 nm.

Meanwhile, instead of using the 45-degree dichroic filter as proposed above in US Patent No. US 7,184,621, there is a method of combining a plurality of wavelengths into one optical fiber by reducing the incident angle on the dichroic filter. FIG. 4 shows an optical commercialization case of US Patent No. US 8,488,244 where the incident angle on the dichroic filter is reduced to about 7 degrees. Here, the incident angle of laser light incident on each dichroic filter is about 7 degrees. If the incident angle deviates from this incident angle by +/- 1 degree, a wavelength shift may occur as shown in FIG. 2. In this case, the wavelength shift may occur by about +/- 1 nm. Therefore, when the guardband is 1 nm or more, a zigzag dichroic filter method may be used to mux a plurality of laser lights into one optical path. However, the zigzag filter is required to have a very large size in order to increase a tolerance of the incident angle to about +/- 1 degree while mixing lights having a guardband wavelength width as narrow as about 0.2 nm. Currently, in order to mix lights having a guardband wavelength width of 32 nm, a zigzag filter is mainly used that has an incident angle of 7 degrees, at which light is incident on the dichroic filter. This zigzag filter is manufactured to have a length of about 4 to 5 mm. However, the size of the zigzag filter is required to be about 16 to 20 mm long when using a zigzag filter having an incident angle of 2 degrees, at which light is incident on the dichroic filter, in order to mix lights having a guardband wavelength width of about 1 nm. It is very difficult to manufacture such a filter of this size, and this filter may occupy a large volume, thus making it difficult to manufacture a small optical device.

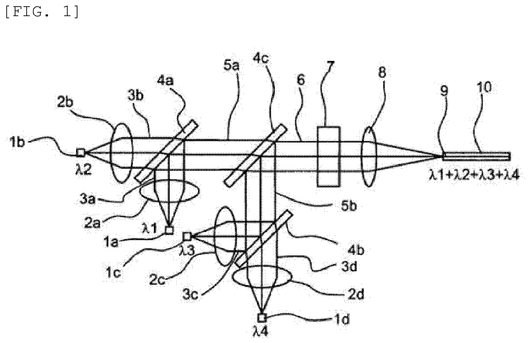

In addition, a dense wavelength division multiplexing (DWDM) technique in which a wavelength interval between the channels is 200 GHz, 100 GHz, or 50G Hz has been recently used in order to increase efficiency of the optical fiber utilization. An example of this DWDM network may include next-generation passive optical network 2 (NG-PON2). The NG-PON2 may include four or eight channels having the interval of 100 GHz. To increase communication capacity of one network access point, current telecommunication companies use a method of bundling the channels of the optical devices to secure the increased communication capacity by having a speed that is two, three, or four times faster than a case of using one optical device. The structure in FIG. 1 or 4 shows that the wavelength interval is at least 3 nm or more, and a channel width allowed for each optical device reaches several nm. A semiconductor laser may be changed by about 0.1 nm per 1°C. Therefore, in the conventional structure in FIG. 1 or 4, an allowable temperature range of each laser diode reaches several tens of degrees Celsius. Accordingly, there is no need to install two or three optical devices and precisely adjust a temperature of each laser diode chip. However, the NG-PON2 may have the wavelength interval of 100GHz. A total width of a channel may be only 0.8 nm, and at least 0.2 nm on each of two sides of 0.8 nm is required to be used as a guardband with the adjacent channel. Therefore, a temperature of the laser diode chip that is allowed for each channel may need to be precisely adjusted to be within at least +/- 2°C, preferably within +/- 1°C, of a center wavelength of the channel.

When applying, to DWDM, a method of increasing the communication capacity through the channel bundling by mounting two or more semiconductor lasers as one and driving the two semiconductor lasers independently or simultaneously in the same manner as shown in FIGS. 1 and 4, the respective lasers are required to simultaneously be +/- 100 pm at the center wavelength of each communication channel, that is, the temperature of each laser diode chip is required to be adjusted within +/- 1°C under an optimal condition.

An oscillation wavelength of each semiconductor laser may be determined by a temperature when manufacturing the semiconductor laser. Therefore, two or more semiconductor lasers may be mounted in one optical device, and in order to simultaneously match the respective semiconductor lasers to the center wavelength of an allowable channel, each laser is required to be independently and precisely adjusted to its temperature. In the case of FIG. 4, although not shown in the drawing, four semiconductor lasers are mounted on one thermoelectric element, and all the four semiconductor lasers are driven at the same temperature. However, in the case of FIG. 4, an allowable wavelength range of each laser is 3 to 4 nm, which has an allowable temperature range of 40°C. The oscillation wavelength may be very precisely measured at each laser diode chip state when the chip is not packaged. However, this wavelength corresponds to a case where the chip is unpackaged. The chip may have a wavelength inaccuracy of at least +/- 5°C when packaged while having this wavelength. However, in the case of FIG. 4, the allowable range is +/-20°C, and chips capable of operating each channel at the same temperature may be selected during a chip selection process. However, when the channels have a channel interval of 100 GHz, it is possible to simultaneously operate two laser diode chips using one thermoelectric element by grouping the wavelengths of the chips at the same temperature of +/- 1°C after packaging the chips. However, this method is practically impossible due to the wavelength inaccuracy when selecting the chips.

Alternatively, there is a method of disposing the plurality of thermoelectric elements in one optical device and disposing the laser diode chip on each thermoelectric element to independently match the oscillation wavelength of each laser diode chip to the allowed channel. However, this method requires more thermoelectric elements, more thermistors for measuring a temperature of each thermoelectric element, and more complex assembly process, and thus be economically disadvantageous.

In addition, in the NG-PON2 or Google's super-passive optical network (PON), the laser diode may be operated in a burst mode in a time division multiplexing (TDM) network where a plurality of subscribers share one channel at a DWDM level. In the burst mode, the laser diode chip may be completely turned off during times that are not allowed for each subscriber, and when a burst on signal comes in and the laser diode chip starts to be operated, a current for driving the laser diode may flow into an active layer of the laser diode chip, thus generating heat and light. Therefore, when a burst mode operation starts, a temperature of the active layer of the semiconductor laser may be changed, which may change the oscillation wavelength of the laser diode. The temperature change in the active layer of the semiconductor laser that occurs when the burst mode starts may easily exceed 10°C, which corresponds to a wavelength shift of about 10 nm, thus making the burst mode operation difficult in the DWDM optical communication with the interval of 100 GHz.

When increasing a speed of the laser diode chip in the optical device, reception sensitivity may be lower, thus making it difficult to increase the maximum number of subscribers. Therefore, it is possible to increase the number of subscribers by using a plurality of low-speed channels rather than high-speed signals, which leads to a need for a method of integrating a plurality of low-speed laser diode chips into one optical device, accurately matching a wavelength of light emitted from each laser diode chip to the allowed channel of the DWDM, and simultaneously suppressing the wavelength shift of the laser diode chip in the burst mode. The above-described conventional technologies have problems in terms of the DWDM, the integration of the plurality of low-speed laser diode chips, and the burst mode operation, and a method to solve these problems is needed.
(Patent Document 0001) US Patent No. US 7,184,621 B1 (registered on February 27, 2007)
(Patent Document 0002) US Patent No. US 78,488,244 B1 (registered on July 16, 2013)

### [Disclosure]

### [Technical Problem]

An object of the present invention is to provide a dense wavelength division multiplexing (DWDM) optical device in which a guardband between channels is within 1 nm, two or more optical devices capable of changing their wavelengths are disposed in one optical device, and a transmission speed may be doubled by operating the respective optical devices simultaneously.

Another object of the present invention is to provide a DWDM optical device in which a heater is mounted on a laser diode chip, and when the laser diode is operated in a burst mode, a temperature of the chip is changed due to self-heating of the chip that is caused by the operation of the laser diode chip, thus suppressing the resulting change in a laser wavelength, and simultaneously, one thermoelectric element and the heater mounted on at least one laser diode chip are used to ensure that wavelengths of light emitted from the plurality of laser diodes exactly match a predetermined DWDM channel.

This patent application is a result of the following national research and development project research project.
Project number: RS-2022-TI016661
Ministry Name: Ministry of SMEs and Startups
Project management (specialized organization) name: Small and Medium Business Technology Information Promotion Agency
Research field name: Investment R&D (Scale Up Tips)
Research project name: Development of 10Gbps-based 8-channel up/downlink 80Gbps NG-PON2 expandable optical device
Contribution rate: 1/1
Name of project carrying out organization: Fovell Co., Ltd.
Research period (total): December 1, 2022 to November 30, 2024

### [Technical Solution]

According to an embodiment of the present invention, provided is an optical device, which includes a laser capable of changing its wavelength, the device including: a thermoelectric element disposed in one optical device package; at least two laser diode chips disposed on the thermoelectric element; and a heater mounted on at least one laser diode chip among the laser diode chips, wherein the at least two laser diode chips are configured to independently emit laser lights at center wavelengths of different communication channels by applying a temperature acquired by operating the heater in addition to a temperature generated by the thermoelectric element for a wavelength of the at least one laser diode chip to match a center wavelength of a predetermined communication channel.

Laser lights emitted from the respective laser diode chips may be changed into polarizations orthogonal to each other, and then combined by a polarization optical combiner and optically transmitted to an optical fiber.

In addition, a half-wave polarizer may be disposed in at least one optical path of laser lights emitted from the respective laser diode chips to change the polarizations of the laser diode chips to be orthogonal to each other, and laser light emitted from the two laser diode chips may then be combined and optically transmitted to the optical fiber by a polarization optical combiner.

Polarizations of laser lights emitted from the respective laser diode chips may be arranged to be orthogonal to each other by changing arrangements of the respective laser diode chips.

The laser diodes, which are a plurality of light sources, may have a structure such as a distributed feedback laser diode (DFB-LD), a DFB-LD-electro absorption modulator (EAM), a distributed bragg reflection laser diode EAM (DBR-LD-EAM), a DFB-LD-EAM-semiconductor optical amplifier (SOA), or a DBR-LD-EAM-SOA, and the plurality of light sources may be formed by combining the light source chips having the above structures.

The laser diode chip may be configured to be operated in a burst mode.

An amount of heat generated by the heater that is injected into the laser diode chip, which is configured to be operated in the burst mode and on which the heater is mounted, may be modulated to thus compensate for some or all of heat generated by Joule heating of the laser diode chip itself, which is configured to be operated in the burst mode.

A sum of an amount of heat generated by the heater that is injected into the laser diode chip, which is configured to be operated in the burst mode and on which the heater is mounted, and an amount of heat generated in the laser diode may be maintained to be constant regardless of whether the burst mode is turned on or off.

The laser diode chip may have a reverse mesa ridge structure, and the heater may be mounted on the reverse mesa ridge structure.

The device may have a wavelength locker function of measuring the wavelength of laser light emitted from the at least one laser diode chip.

### [Advantageous Effects]

The optical device of the present invention, in which two or more light source chips are mounted in the DWDM optical communication network whose wavelength interval is within 200 GHz or 100 GHz, may achieve the precise wavelength control of each light source by using the temperature control of the thermoelectric element on which the respective optical devices are commonly mounted, and the heater built in at least one light source chip to thus adjust the emission wavelengths of the plurality of light source chips to match the set DWDM channel, which may secure the economic efficiency by employing the fewer thermoelectric elements, and the increased DWDM-level data transmission capacity by operating the plurality of light source chips simultaneously.

In addition, the optical device may achieve the smooth transmission by suppressing the fluctuation of laser light emitted from each laser diode chip by Joule heating when the laser diode chip is configured to be operated in the burst mode.

### [Description of Drawings]

FIG. 1 is a configuration diagram showing a conventional method of implementing four laser diode chips having a wavelength interval of 20 nm or more into one optical device.
FIG. 2 is a graph of a transmission wavelength feature curve based on an incident angle of a 45 degree filter.
FIG. 3 is a conceptual diagram of transmission/reflection/guardband of a wavelength filter.
FIG. 4 shows a configuration diagram showing a conventional method of implementing four chips having 4 nm guardband into one optical device.
FIG. 5 is a feature graph of a polarization combiner showing a transmission/reflection feature based on its incidence angle.
FIG. 6 shows an example of a temperature change in a laser diode (LD) active layer area when 100 mW is applied to the LD active layer area.
FIG. 7 shows an example of a temperature change in an LD active area when 100 mW is applied to a heater area and then stopped.
FIG. 8 shows an example of a temperature change in an LD active area when 100 mW is applied to a heater area and then stopped and the laser diode is driven at 100mW.
FIG. 9 is a configuration diagram of combination of a plurality of light source chips for DWDM channels having a wavelength interval narrower than 200 GHz, proposed in the present invention.
FIG. 10 is a conceptual diagram of using a heater to cause a wavelength of an upper-channel chip to reach a target wavelength when a wavelength of a lower-channel light source according to the present invention first reaches the target wavelength by a thermoelectric element.
FIG. 11 is a conceptual diagram of using a heater to cause a wavelength of a lower-channel chip to reach the target wavelength when a wavelength of an upper-channel light source according to the present invention first reaches the target wavelength by the thermoelectric element.
FIG. 12 is a conceptual diagram showing a method of adjusting an amount of heat generated in the LD and an amount of heat generated by the heater when the wavelength reaches the target wavelength by the thermoelectric element.
FIG. 13 is a conceptual diagram showing a method of adjusting an amount of heat generated in the LD and an amount of heat generated by the heater when the wavelength reaches the target wavelength by the thermoelectric element plus (+) heater power.
FIG. 14 is a conceptual diagram showing a method of driving power for the LD and the heater when the wavelength reaches the target wavelength by the thermoelectric element.

### [DETAILED DESCRIPTION]

Hereinafter, specific embodiments of the present invention are described under the premise of not limiting the scope of the present invention.

The description describes that an optical device in the present invention is applied to an optical device for dense wavelength division multiplexing (DWDM) channels having a channel interval of 200 GHz or less.

However, it should be noted that regardless of the explanation in the present invention, the spirit of the present invention may be applied and utilized in various forms, and all of these applications are within the spirit and scope of the present invention.

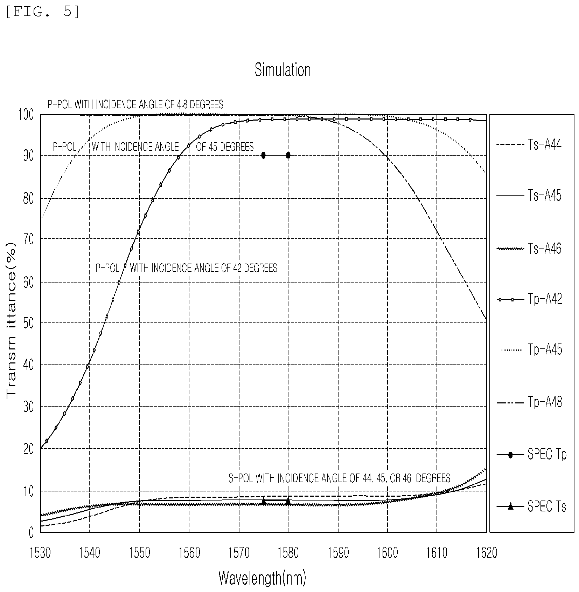

FIG. 5 is a graph showing a feature of a polarization combiner applied to the present invention.

The polarization combiner may be manufactured by depositing a plurality of layers of thin films having high and low refractive indexes on a material transparent to light, such as glass or quartz. As shown in FIG. 5, 90% or more of P-polarized light may be transmitted and 90% or more of S-polarized light may be reflected in a wavelength range of about 40 nm even when an incident angle deviates to 42 degrees or 48 degrees based on the incident angle of 45 degrees. Therefore, when used as an optical combiner combining two optical paths, this polarization combiner may eliminate difficulties that stem from a large transmission/reflection ratio change even by a minute incident angle change as shown in FIG. 2.

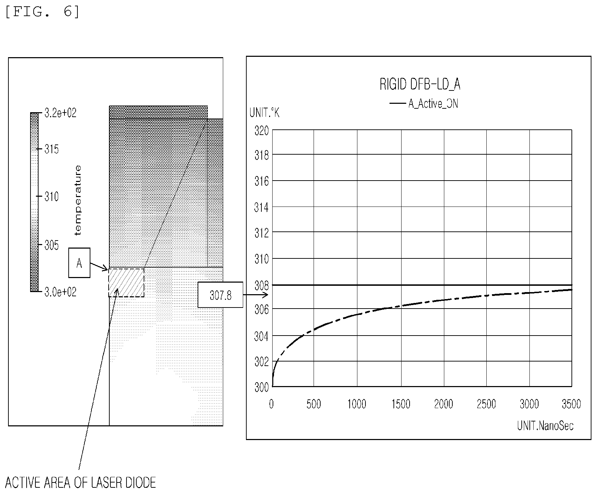

FIG. 6 shows a temperature change in the laser active area over time when 100 mW of power is applied to an active layer of a distributed feedback laser diode (DFB-LD) having a ridge structure in a burst mode. Typically, a time length of a burst signal may be about 10 micro-sec. During this time, the laser active area shows a temperature change of 8°C or more, which is a wavelength change large enough to affect an adjacent channel. Therefore, it is necessary to suppress this wavelength change.

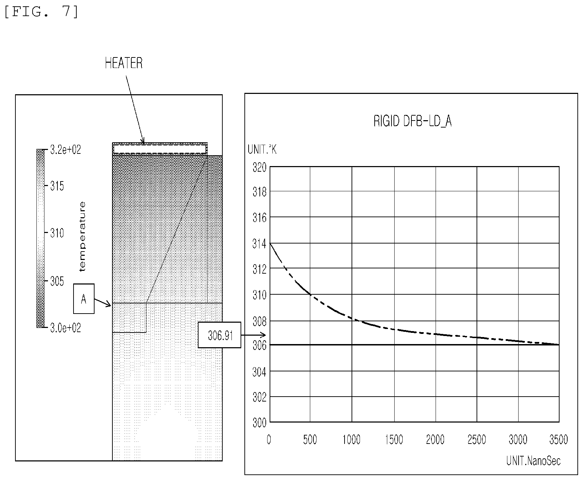

FIG. 7 shows a temperature change in the laser active layer when a heater is mounted on the upper side of the DFB-LD having the ridge structure, and the heater is operated at the power of 100 mW, and then stopped at a time point at which a laser burst operation starts.

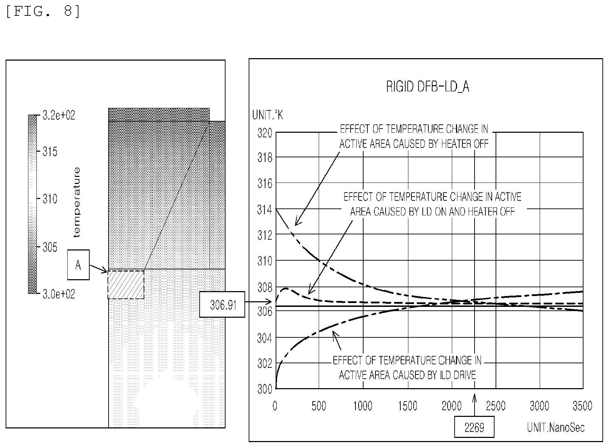

FIG. 8 shows a temperature change in the laser active area when the heater is operated at 100 mW, and then stopped in response to a burst signal, and the laser diode is driven at 100 mW simultaneously. An LD-on effect and a heater-off effect show that the temperature change in the LD active area is effectively suppressed.

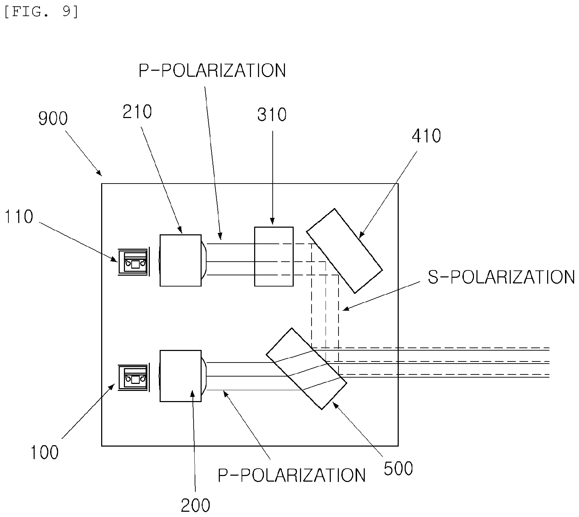

FIG. 9 is a conceptual diagram showing a method of combining a plurality of light source chips for dense wavelength division multiplexing (DWDM) channels having a wavelength interval narrower than 200 GHz, proposed in the present invention.

FIG. 9 shows an example of integrating two laser diode chips into one optical device, and more laser diode chips may be mounted therein. In the present invention, it is assumed that the heaters are mounted on both of a lower-channel laser diode chip 100 and an upper-channel laser diode chip 110. However, the heater may be mounted on only one chip. In this case, a wavelength of the chip with no heater may be adjusted using a thermoelectric element 900.

In an embodiment of the present invention, each of the lower-channel laser diode chip 100 and the upper-channel laser diode chip 110 may be a chip for four channels.

Each laser diode chip 100 or 110 is described as having p-polarization. However, both the chips may have s-polarization or one chip may have the s-polarization and the other chip may have the p-polarization. A half-wave polarizer 310 of the present invention may not be needed when the laser diode chips 100 and 110 have different polarizations. P-polarized laser lights emitted from the laser diode chips 100 and 110 may be collimated to be parallel to each other through respective parallel light lenses 200 and 210. The half-wave polarizer 310 may be disposed in an optical path of one of the two p-polarizations to change the p-polarization into the s-polarization. A total reflection mirror 410 may be disposed in the optical path where the polarization is changed, and transmit s-polarized light to a polarization optical combiner 500.

The polarization optical combiner 500 may reflect s-polarized light and transmit p-polarized light, combine lights from the respective laser diode chips 100 and 110 regardless of the wavelength, and transmit combined light to an optical fiber not shown in the drawing, thereby transmitting a signal. In this way, it is possible to manufacture the optical device having the plurality of the laser diode chips 100 and 110, use the thermoelectric element 900 and the heaters mounted on the laser diode chips 100 and 110 to thus independently and accurately match wavelengths of the plurality of laser diodes chips 100 and 110 to a center wavelength of a predetermined channel.

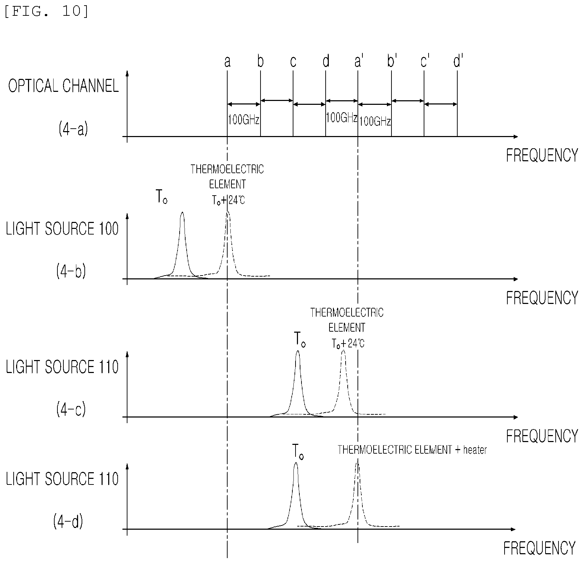

FIG. 10 shows that the wavelength of the lower-channel laser diode chip 100 shown in FIG. 9 is set to the thermoelectric element 900, here, when the wavelength of the upper-channel laser diode chip 110 does not reach a target wavelength, a temperature of the laser diode chip 110 is further adjusted by driving the heater of the laser diode chip 110 to thus shift a frequency of a light source of the upper-channel laser diode 110 to accurately match a center wavelength of an assigned channel.

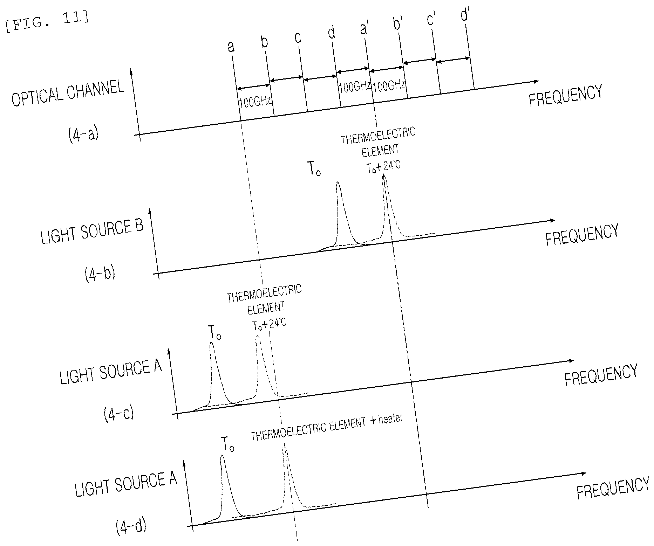

FIG. 11 shows that the wavelength of the upper-channel laser diode chip 110 shown in FIG. 9 is set to the thermoelectric element 900, here, when the wavelength of the lower-channel laser diode chip 100 does not reach the target wavelength, a temperature of the laser diode chip 100 is adjusted by driving the heater of the laser diode chip 100 to thus shift a frequency of a light source of the lower-channel laser diode chip 100 to accurately match the center wavelength of the assigned channel.

In FIGS. 6 and 8, heater power and power injected into the laser diode may be equally converted to heat. However, while the power injected into the heater may be converted into heat, the power injected into the laser diode may be converted into heat and light. Therefore, an effect on the temperature in the laser diode active area may correspond to a portion of the power injected into the laser diode that is converted to heat, excluding a portion of the power that is converted to light and exits.

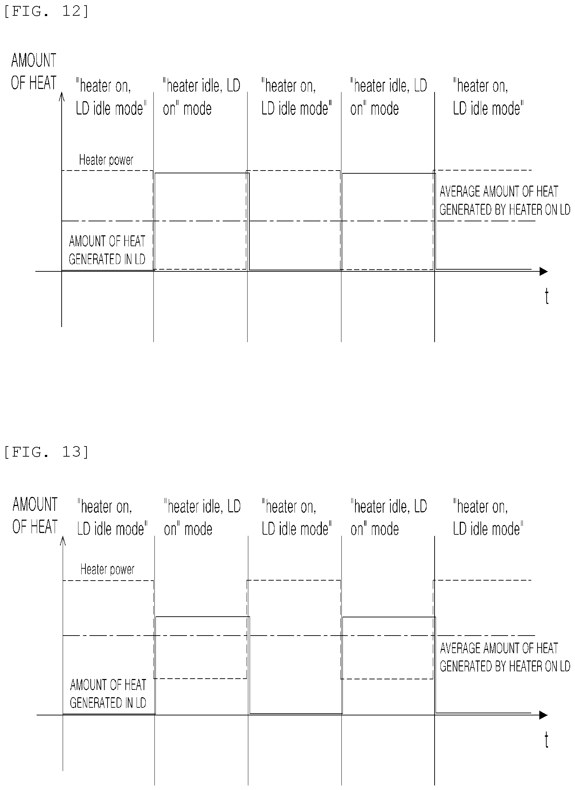

Referring to FIG. 12, when the laser diode chip reaches the target wavelength by operating only the thermoelectric element, heat generated in the laser diode (LD) may be injected alternately with the heater power to offset the wavelength change caused by Joule heating of the laser diode (LD) itself due to the burst mode operation.

Referring to FIG. 13, when the laser diode chip reaches the target wavelength by operating the thermoelectric element and the heater simultaneously, the heater power may be modulated and injected as shown in FIG. 13 to offset the wavelength change caused by Joule heating of the laser diode itself due to the burst mode operation.

As shown in FIGS. 12 and 13, it is preferable to maintain the sum of an amount of heat generated by driving the laser diode (LD) and an amount of heat by driving the heater to be constant regardless of whether the burst mode is operated or not.

With reference to FIGS. 12 and 13, the description describes a process in which the amount of heat generated by driving the laser diode is complementary, and from an electrical perspective, only a portion of the power injected into the laser diode (LD) may be converted into heat.

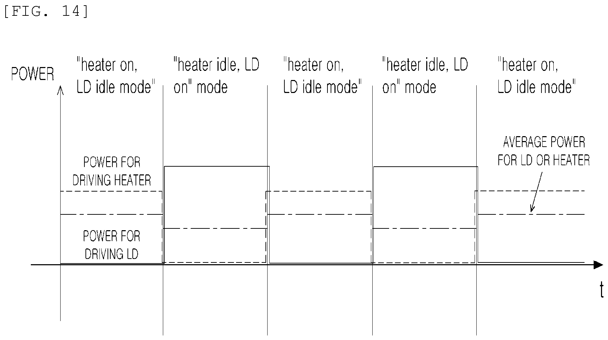

Referring to FIG. 14, the power for the heater to offset the wavelength change caused by Joule heating may be smaller than the power injected into the laser diode (LD) in FIG. 14. Therefore, the power injected into the laser diode (LD) and the power injected into the heater may be substantially different during the burst mode operation and an idle mode operation.

The present invention may include all the processes of using the thermoelectric element and the heater to thus accurately match the plurality of laser diodes to a target optical channel and modulate the heater power, and offsetting some or all of the wavelength change in the laser diode that is caused by Joule heating of the laser diode (LD) itself.

Meanwhile, the description of the present invention takes the DFB-LD as an example of the light source chip (or laser diode chip). However, the light source chip may be applied to light sources having various structures such as a DFB-LD-electro absorption modulator (EAM), the DFB-LD-EAM, a distributed bragg reflection laser diode EAM (DBR-LD-EAM), and a DFB-LD-EAM-semiconductor optical amplifier (SOA). Alternatively, various combinations of these light source chips are also possible.

As a preferred embodiment of the present invention, it is preferable that the DFB-LD, the DFB-LD-EAM, the DBR-LD, or the like may have the ridge structure in which the heater is mounted on the LD. In particular, it is preferable for the heater to be mounted on a reverse mesa ridge structure for the heater to be easily mounted on the light source.

In addition, although omitted in the description of the present invention, it is also preferable to add a wavelength locker function of measuring the wavelength of at least one laser diode chip disposed in the optical device package.

As described above, the present invention is not limited to the above-described embodiments, and may be modified and changed in various ways by those skilled in the art to which the present invention pertains within the spirit of the present invention and a scope equivalent to the scope of the following claims.

## Claims

1. An optical device, which includes a laser capable of changing its wavelength, the device comprising:
a thermoelectric element disposed in one optical device package;
at least two laser diode chips disposed on the thermoelectric element; and
a heater mounted on at least one laser diode chip among the laser diode chips,
wherein the at least two laser diode chips are configured to independently emit laser lights at center wavelengths of different communication channels by applying a temperature acquired by operating the heater in addition to a temperature generated by the thermoelectric element for a wavelength of the at least one laser diode chip to match a center wavelength of a predetermined communication channel.

2. The device of claim 1, in which laser lights emitted from the respective laser diode chips are changed into polarizations orthogonal to each other, further comprising a polarization optical combiner configured to combine laser lights emitted from the respective laser diode chips and transmit combined laser light to an optical fiber.

3. The device of claim 2, further comprising a half-wave polarizer disposed in an optical path of laser light emitted from one of the laser diode chips and configured to change polarizations of the laser diode chips to be orthogonal to each other,
wherein the polarization optical combiner is configured to combine laser light received from the half-wave polarizer with laser light received directly from the other laser diode chip without going through the half-wave polarizer to thus optically transmit combined laser light to the optical fiber.

4. The device of claim 1, wherein polarizations of laser lights emitted from the respective laser diode chips are arranged to be orthogonal to each other by changing arrangements of the respective laser diode chips.

5. The device of claim 1, wherein the laser diodes, which are a plurality of light sources, have a structure such as a distributed feedback laser diode (DFB-LD), a DFB-LD-electro absorption modulator (EAM), a distributed bragg reflection laser diode EAM (DBR-LD-EAM), a DFB-LD-EAM-semiconductor optical amplifier (SOA), or a DBR-LD-EAM-SOA, and
the plurality of light sources are formed by combining the light source chips having the above structures.

6. The device of claim 1, wherein the laser diode chip is configured to be operated in a burst mode.

7. The device of claim 6, wherein an amount of heat generated by the heater that is injected into the laser diode chip, which is configured to be operated in the burst mode and on which the heater is mounted, is modulated to thus offset for some or all of heat generated by Joule heating of the laser diode chip itself, which is configured to be operated in the burst mode.

8. The device of claim 6, wherein a sum of an amount of heat generated by the heater that is injected into the laser diode chip, which is configured to be operated in the burst mode and on which the heater is mounted, and an amount of heat generated in the laser diode is maintained to be constant regardless of whether the burst mode is turned on or off.

9. The device of claim 1, wherein the laser diode chip has a reverse mesa ridge structure, and the heater is mounted on the reverse mesa ridge structure.

10. The device of claim 1, wherein the device has a wavelength locker function of measuring the wavelength of laser light emitted from the at least one laser diode chip.
